# EUROPÄISCHE PATENTANMELDUNG

(11) **EP 3 145 082 A1**
(43) Veröffentlichungstag der Anmeldung: **22.03.2017**
(21) Anmeldenummer: 16187189.2
(22) Anmeldetag: 05.09.2016
(51) Int. Cl.: H03K 17/96, F24C 7/08

(54) **BEDIENEINRICHTUNG FÜR EIN ELEKTROGERÄT, ELEKTROGERÄT UND VERFAHREN ZUR HERSTELLUNG EINER BEDIENEINRICHTUNG**

(30) Priorität: 17.09.2015 DE 102015217856
(71) Anmelder: E.G.O. Elektro-Gerätebau GmbH, 75038 Oberderdingen (DE)
(72) Erfinder: Graff, Frank, 16818 Radensleben (DE); Kuehn, Henry, 16540 Hohen Neuendorf (DE); Rominger, Michael, 78078 Niedereschach (DE); Schmidt, Kay, 75038 Flehingen (DE)
(74) Vertreter: Patentanwälte Ruff, Wilhelm, Beier, Dauster & Partner mbB

(57) **Zusammenfassung**

Eine Bedieneinrichtung für ein Elektrogerät weist einen kapazitiven Berührungsschalter mit kapazitivem Sensorelement und ein Bediengehäuse auf, wobei das Sensorelement auf einer Trägerfolie angeordnet ist, auf der elektrische Leiter zum Anschluss des Sensorelements zu einer Anschlusseinrichtung an der Trägerfolie verlaufen. Das Bediengehäuse weist eine flache Bediengehäuseoberseite auf mit einem nach unten abstehenden umlaufenden Bediengehäuserand, an deren Unterseite die Trägerfolie befestigt ist. In dem Bediengehäuse ist unterhalb der Trägerfolie ein Bauteilträger mit elektrischen Bauteilen und einer Leuchtanzeige vorgesehen, der Bauteilträger an die Trägerfolie elektrisch angeschlossen ist, wobei die Trägerfolie und die Bediengehäuseoberseite zumindest bereichsweise lichtdurchlässig sind oberhalb der Leuchtanzeige.

## Beschreibung

### Anwendungsgebiet und Stand der Technik

Die Erfindung betrifft eine Bedieneinrichtung für ein Elektrogerät mit mindestens einem kapazitiven Berührungsschalter, ein Elektrogerät mit einer solchen Bedieneinrichtung sowie ein Verfahren zur Herstellung einer solchen Bedieneinrichtung.

Aus der EP 859467 A1 ist eine Bedieneinrichtung für ein Kochfeld bekannt mit mehreren kapazitiven Berührungsschaltern.

Aus der DE 102013211296 A1 ist eine weitere solche Bedieneinrichtung für ein Kochfeld bekannt, welche kapazitive Berührungsschalter aufweist, wobei die kapazitiven Berührungsschalter auf einer Leiterplatte als Träger angeordnet sind und in einem Bediengehäuse untergebracht sind.

### Aufgabe und Lösung

Der Erfindung liegt die Aufgabe zugrunde, eine eingangs genannte Bedieneinrichtung, ein damit versehenes Elektrogerät sowie ein Verfahren zur Herstellung einer solchen Bedieneinrichtung zu schaffen, mit denen Probleme des Stands der Technik gelöst werden können und es insbesondere möglich ist, kapazitive Berührungsschalter bzw. dafür vorgesehene kapazitive Sensorelemente auf praxistaugliche Art und Weise in einem Bediengehäuse anzuordnen.

Gelöst wird diese Aufgabe durch eine Bedieneinrichtung mit den Merkmalen des Anspruchs 1, ein Elektrogerät mit den Merkmalen des Anspruchs 12 sowie ein Verfahren mit den Merkmalen des Anspruchs 14. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung, für das Elektrogerät oder für das Herstellungsverfahren beschrieben. Sie sollen jedoch unabhängig davon sowohl für die Bedieneinrichtung als auch für das Elektrogerät und für das Herstellungsverfahren selbständig und unabhängig voneinander gelten können. Der Wortlaut der Ansprüche wird durch ausdrückliche Bezugnahme zum Inhalt der Beschreibung gemacht.

Es ist vorgesehen, dass die Bedieneinrichtung für das Elektrogerät mindestens einen kapazitiven Berührungsschalter und ein Bediengehäuse aufweist. Der kapazitive Berührungsschalter weist ein kapazitives Sensorelement auf bzw. wird auch durch ein solches gebildet. Dieses Sensorelement wiederum ist auf einer Trägerfolie bzw. einem dünnen und elastischen und flexiblen Träger angeordnet, beispielsweise einer sogenannten Flexleiterplatte, vorteilhaft hergestellt durch ein entsprechend bekanntes Beschichtungsverfahren. Auf der Trägerfolie sind auch elektrische Leiter vorgesehen, um insbesondere das kapazitive Sensorelement elektrisch anzuschließen. Dazu verlaufen sie zu einer Anschlusseinrichtung, die an der Trägerfolie vorgesehen bzw. befestigt ist. Eine solche Anschlusseinrichtung kann eine fertige Steckverbindung sein, insbesondere eine Steckerbuchse. Alternativ können es einfache Kontaktfelder zur Kontaktierung durch Anlegen oder Aufklemmen bzw. Anschweißen oder Anlöten sein. Das Bediengehäuse weist eine flache Bediengehäuseoberseite auf, die unten und/oder oben sogar eben bzw. plan ausgebildet sein kann. Des Weiteren weist das Bediengehäuse einen zumindest teilweise nach unten abstehenden Bediengehäuserand auf, der zumindest teilweise, vorteilhaft weitgehend, umläuft bzw. umlaufend ausgebildet ist. Somit ist das Bediengehäuse nach unten weitgehend offen, wobei hier zum Verschluss eine Bodenplatte odgl. vorgesehen sein kann. Des Weiteren ist die Trägerfolie an der Unterseite der Bediengehäuseoberseite befestigt, also sozusagen von unten in das Bediengehäuse eingebracht und dann darin befestigt.

Erfindungsgemäß ist vorgesehen, dass in dem Bediengehäuse unterhalb der Trägerfolie noch ein Bauteilträger mit elektrischen Bauteilen und mit mindestens einer Leuchtanzeige der Bedieneinrichtung oder für die Bedieneinrichtung vorgesehen ist. So kann die Trägerfolie weitgehend oder ausschließlich die kapazitiven Sensorelemente samt den elektrischen Leitern und der Anschlusseinrichtung aufweisen, während die Hauptbestandteile für eine Bedieneinrichtung bzw. zur Steuerung des Elektrogeräts auf diesem Bauteilträger angeordnet sind. So kann die Trägerfolie auch flach ausgebildet sein sowie ihre Flexibilität bewahren, die durch aufgebrachte Bauteile wie SMD-Bauteilen odgl. beeinträchtigt werden würde. Die Trägerfolie ist an den Bauteilträger elektrisch angeschlossen, vorteilhaft durch die genannte Anschlusseinrichtung. Schließlich sind die Trägerfolie und die Bediengehäuseoberseite zumindest bereichsweise lichtdurchlässig, und zwar vorteilhaft oberhalb der genannten Leuchtanzeige. So ist diese durch die Bediengehäuseoberseite und durch die Trägerfolie hindurch erkennbar.

Somit ist mit der Erfindung eine sehr gute Integration eines kapazitiven Berührungsschalters und einer Leuchtanzeige in eine Bedieneinrichtung möglich, insbesondere in eine Bedieneinrichtung mit einem Bediengehäuse. Durch die Anordnung in einem solchen Bediengehäuse ist zum einen eine eigenständig handhabbare Baueinheit erreicht, zum anderen kann eine thermische Dämmung, elektrische Isolation und auch ein Schutz vor Feuchtigkeit erreicht werden. Vor allem kann eine solche Bedieneinrichtung, die nicht nur ein Bediengehäuse aufweist, sondern weitgehend in diesem Bediengehäuse angeordnet ist, leicht in ein Elektrogerät eingebaut werden, beispielsweise unter eine Bedienblende oder eine Bedienoberfläche wie beispielsweise bei einem Kochfeld unter einer Kochfeldplatte oder bei einem sonstigen Elektrogerät eine Vorderseite oder Oberseite.

In vorteilhafter Ausgestaltung der Erfindung ist die Trägerfolie an der Unterseite der Bediengehäuseoberseite dauerhaft und unlösbar befestigt, insbesondere kann sie integral mit dieser hergestellt sein, alternativ mittels Kunststoffspritzguss an eine fertige Bediengehäuseoberseite angespritzt sein, also in einem Bediengehäuse durch Anspritzen befestigt sein. Bei einer solchen sogenannten In-Mould-Methode ist auch eine exakte Anordnung der kapazitiven Berührungsschalter bzw. kapazitiven Sensorelemente zum Bediengehäuse bzw. zur Bediengehäuseoberseite erreicht, was für die Funktionsweise von kapazitiven Berührungsschaltern sehr wichtig ist. Dazu kann die Trägerfolie vor dem Anspritzen direkt an die Unterseite der Bediengehäuseoberseite angelegt sein.

Vorteilhaft liegt dabei die Trägerfolie großflächig bzw. vollflächig an der Unterseite der Bediengehäuseoberseite an. Dies erfolgt möglichst ohne Einschluss von Luftblasen odgl., so dass also keine Luftspalte entstehen. Diese beeinträchtigen die Funktionsweise eines kapazitiven Berührungsschalters nämlich sehr negativ.

Bei der Anordnung der Trägerfolie in dem Bediengehäuse kann vorgesehen sein, dass die Anschlusseinrichtung der Trägerfolie noch zugänglich ist bzw. frei absteht, wenn die Trägerfolie an der Unterseite der Bediengehäuseoberseite befestigt worden ist. So ist ein guter und sicherer elektrischer Anschluss an den Bauteilträger bei dessen Einbau in das Bediengehäuse möglich.

Der Bauteilträger wird vorteilhaft im Bediengehäuse befestigt und eben mittels der genannten Anschlusseinrichtung mit der Trägerfolie elektrisch verbunden, so dass die darauf vorhandenen kapazitiven Sensorelemente ausgewertet und verwendet werden können. Eine Befestigung des Bauteilträgers im Bediengehäuse kann vorteilhaft auf an sich bekannte Art und Weise erfolgen, beispielsweise kann nach Anstecken oder Anschließen der Anschlusseinrichtung der Bauteilträger auf Führungsvorsprünge gesteckt und mittels Rasteinrichtungen odgl. befestigt werden.

Für die Trägerfolie und den Bauteilträger kann vorteilhaft gelten, dass mindestens ein kapazitives Sensorelement oberhalb der Leuchtanzeige auf dem Bauteilträger angeordnet ist, besonders vorteilhaft direkt über der Leuchtanzeige. Somit ist es möglich, dass eine Bedienperson den Finger oberhalb dieser Leuchtanzeige auf eine Bedienblende oder ein Bedienfeld auflegt und dann den durch dieses kapazitive Sensorelement gebildeten kapazitiven Berührungsschalter bedient. Es können aber auch kapazitive Sensorelemente neben derartigen Leuchtanzeigen vorgesehen sein. Die Leuchtanzeigen selbst können allgemein ausgebildet sein wie im Stand der Technik bekannt, entweder nur als leuchtende Fläche, also leuchtendes Symbol oder als beleuchtetes und veränderbares Symbol, beispielsweise durch Sieben-Segment-Anzeigen gebildet von LED.

In Ausgestaltung der Erfindung ist der lichtdurchlässige Bereich der Bediengehäuseoberseite im Wesentlichen lichtdurchlässig bzw. zu mindestens 90% durchsichtig. Dazu kann er vorteilhaft ein eingesetztes Fenster aus entsprechend lichtdurchlässigem Material aufweisen. Alternativ und vorteilhaft ist der Großteil der Bediengehäuseoberseite lichtdurchlässig und aus lichtdurchlässigem Material hergestellt, wobei eine Maskierung oder Abdeckung die Lichtdurchlässigkeit auf bestimmte Bereiche beschränkt, die eben lichtdurchlässig oder durchsichtig sein sollen bzw. durch welche hindurch die Leuchtanzeigen erkennbar sein sollen.

In ähnlicher Form ist die Trägerfolie nicht nur bereichsweise lichtdurchlässig, sondern insgesamt lichtdurchlässig bzw. besteht aus einem an sich lichtdurchlässigen oder sogar zu mindestens 90% durchsichtigen Material. Eine vorgenannte Maskierung oder Abdeckung braucht an der Trägerfolie nicht vorgesehen zu sein, da dies durch die darüberliegende Bediengehäuseoberseite mit einer solchen Maskierung bzw. Abdeckung übernommen wird.

In Ausgestaltung der Erfindung kann das Bediengehäuse integral und einteilig hergestellt sein. Dabei kann es vorteilhaft aus einem durchgehend gleichen Material ausgebildet sein, so dass die Herstellung, insbesondere ein Kunststoffspritzvorgang, einfacher ist. Angesichts der vorgenannten Ausbildung zumindest eines Bereichs der Bediengehäuseoberseite aus lichtdurchlässigem oder durchsichtigem Material sollte das gesamte Bediengehäuse aus diesem lichtdurchlässigen bzw. durchsichtigen Material hergestellt sein. Durch die relativ einfache nachträgliche Anbringung der Abschirmung bzw. Abdeckung kann die Lichtdurchlässigkeit auf die gewünschten Bereiche eingeschränkt werden. Eine solche Abschirmung oder Abdeckung kann sowohl auf die Außenseite als auch auf die Innenseite des Bediengehäuses aufgebracht werden. Sie kann nicht nur an der Bediengehäuseoberseite vorgesehen sein, sondern auch an dem vorgenannten seitlichen Bediengehäuserand. So kann ein seitliches Abstrahlen von Licht, unter Umständen auf ungewünschte Art und Weise, vermieden werden. Die vorgenannte Abschirmung bzw. Abdeckung sollte daneben mindestens einen entsprechenden Ausschnitt aufweisen, der die Leuchtanzeigen auf dem Bauteilträger freilässt, so dass sie von oben zu sehen sind.

Der nach unten stehende, weitgehend umlaufende Bediengehäuserand dient dazu, dass darin der Bauteilträger aufgenommen werden kann. Des Weiteren kann er dazu dienen, wenn er an einer Unterkante eine Ebene definiert, dass er damit auf einer großflächigen Unterlage, beispielsweise auf einer Tragplatte oder einem Tragblech eines Kochfelds, aufliegt und so die Anordnung der Bedieneinrichtung bzw. des Bediengehäuses in dem Elektrogerät sicher und stabil ist. In weiterer Ausgestaltung der Erfindung können an dem unteren Bereich des Bediengehäuserands, vorteilhaft an der Unterkante, Dichtmittel nach unten vorgesehen sein. Sie können beispielsweise als Dichtlippe oder Dichtschnur ausgebildet sein. Diese Dichtmittel können eine abgedichtete Anlage auf der vorgenannten Unterlage schaffen. So ist insbesondere ein Schutz gegen Eindringen von Schmutz und/oder Feuchtigkeit gewährleistet. Derartige Dichtmittel können nachträglich bzw. separat angeordnet sein, alternativ können sie auch direkt angespritzt sein. Dann entfällt ein nachträglicher Montageschritt.

Ein erfindungsgemäßes Elektrogerät kann ein Kochfeld mit einer lichtdurchlässigen Kochfeldplatte sein, welche vorteilhaft eine an sich bekannte Glaskeramik-Kochfeldplatte oder eine Hartglas-Kochfeldplatte ist. Das Kochfeld weist eine vorbeschriebene Bedieneinrichtung auf, welche unter der Kochfeldplatte angeordnet ist bzw. welche an die Unterseite der Kochfeldplatte angedrückt ist. So liegt die Bediengehäuseoberseite vorteilhaft direkt an der Unterseite der Kochfeldplatte an, unter Umständen mit einer elastischen Anpassungsschicht odgl. dazwischen. Die Bedieneinrichtung weist dabei mit den kapazitiven Sensorelementen bzw. den davon gebildeten kapazitiven Berührungsschaltern die Eingabeelemente für das Kochfeld auf, wobei auf dem vorbeschriebenen Bauteilträger eine Steuerung sowie wesentliche Teile für die Funktionen der Steuerung des Kochfelds vorgesehen sind. Andere Elektrogeräte können Spülmaschinen, Waschmaschinen, Backöfen, Dunstabzugshauben odgl. sein.

Um die Bedieneinrichtung an die Unterseite der Kochfeldplatte anzudrücken, kann vorgesehen sein, dass sie auf eine an sich übliche Tragplatte bzw. ein sogenanntes Tragblech des Kochfelds aufgelegt ist. Hier sollten mechanische Positionsmarkierungen vorgesehen sein, damit die Bedieneinrichtung bzw. deren Bediengehäuse an der exakt richtigen Stelle anliegt. Es sollten auch Haltemittel vorgesehen sein, um zu verhindern, dass die Bedieneinrichtung seitlich verschoben wird. Diese können rastend oder einfach nur eine seitliche Bewegung begrenzend ausgebildet sein. Durch das Andrücken an die Unterseite der Kochfeldplatte ist eigentlich eine Bewegung der Bedieneinrichtung bei zusammengebautem Kochfeld nicht mehr möglich, zumindest ein Abheben.

Bei einem erfindungsgemäßen Verfahren zur Herstellung einer vorbeschriebenen Bedieneinrichtung wird eine Trägerfolie hergestellt mit den darauf angeordneten kapazitiven Sensorelementen und den elektrischen Leitern. Dann wird diese mit einer vorgenannten Anschlusseinrichtung versehen, beispielsweise für einen Steckanschluss bzw. als Steckanschlusseinrichtung. Diese Trägerfolie wird dann an der Unterseite der Bediengehäuseoberseite befestigt, wobei das Bediengehäuse selbst schon ein weitgehend fertig hergestelltes Teil ist. Diese Befestigung kann beispielsweise mittels Kunststoffspritzguss erfolgen als vorbeschriebenes In-Mould-Verfahren. Alternativ kann eine Verklebung vorgesehen sein oder ein Einklemmen. Es ist auch möglich, die Trägerfolie bei Herstellung des Bediengehäuses bzw. der Bediengehäuseoberseite direkt zu integrieren bzw. einzuspritzen.

Anschließend wird ein Bauteilträger mit den vorgenannten elektrischen Bauteilen und/oder einer Steuerung der Bedieneinrichtung, insbesondere mittels eines Mikrocontrollers, in dem Bediengehäuse unterhalb der Trägerfolie angeordnet. Dazu können eben in dem Bediengehäuse Positioniermittel und Haltemittel wie Rasthaken odgl. vorgesehen sein, an welchen der Bauteilträger durch einfaches Andrücken bzw. Aufdrücken befestigt wird.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen:
- Fig. 1: ein Bediengehäuse, eine Trägerfolie und einen Bauteilträger für eine erfindungsgemäße Bedieneinrichtung in auseinandergezogener Darstellung,
- Fig. 2: die drei Teile für die Bedieneinrichtung aus Fig. 1 auseinandergezogen in Seitenansicht und
- Fig. 3: ein erfindungsgemäßes Kochfeld mit einer darunter angeordneten erfindungsgemäßen Bedieneinrichtung im montierten Zustand.

### Detaillierte Beschreibung der Ausführungsbeispiele

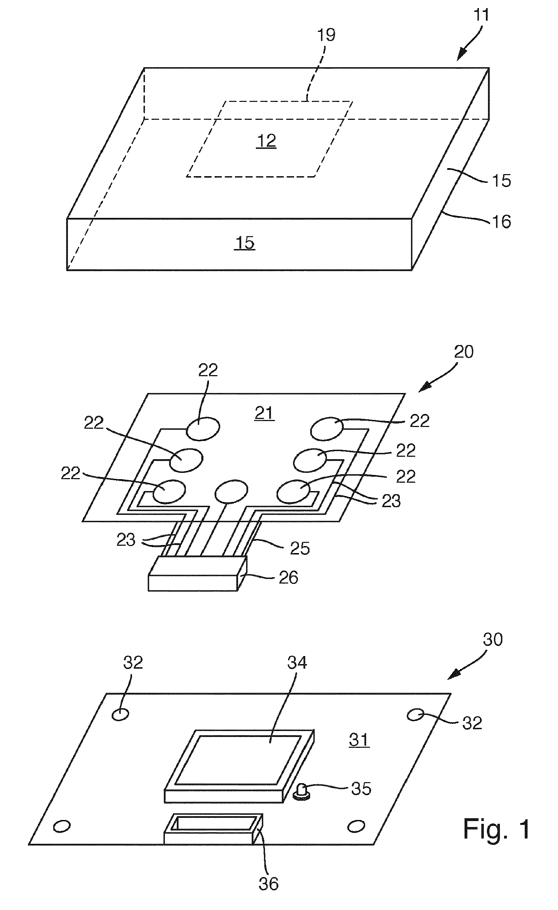

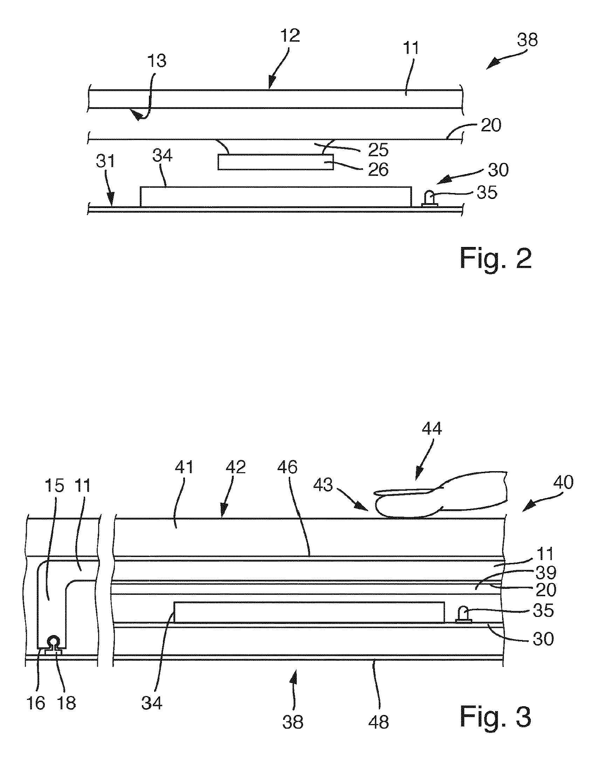

In Fig. 1 ist ein Bediengehäuse 11für eine erfindungsgemäße Bedieneinrichtung in schräger Draufsicht dargestellt, welches hier sehr vereinfacht ausgebildet ist. Die drei dargestellten Teile sind auseinandergezogen, um sie im Einzelnen besser zu sehen. Das im Wesentlichen rechteckige Bediengehäuse 11 weist eine Bediengehäuseoberseite 12 und, wie die Fig. 2 zeigt, eine Bediengehäuseunterseite 13 auf. Außen umlaufend ist an allen vier Seiten ein Bediengehäuserand 15 vorgesehen, der nach unten gezogen ist und überall gleiche Höhe aufweist. An der Unterseite des Bediengehäuserands 15 verläuft eine Unterkante 16, die in einer Ebene verläuft. Hier nicht dargestellt ist ein Durchbruch oder eine Kabelöffnung odgl. im Bediengehäuserand 15 zum Anschluss einer dadurch gebildeten Bedieneinrichtung nach außen an ein erfindungsgemäßes Elektrogerät bzw. ein in Fig. 3 dargestelltes Kochfeld, das von der Bedieneinrichtung gesteuert werden kann.

Wie eingangs beschrieben worden ist, sollte zumindest ein Teil der Bediengehäuseoberseite 12 lichtdurchlässig oder durchsichtig sein. Dies kann allgemein durch ein eingesetztes oder unter Umständen aus einem anderen Material eingespritztes Fenster aus entsprechend durchsichtigem Material erreicht werden. Alternativ und vorteilhaft besteht das gesamte Bediengehäuse 11 aus einem entsprechend lichtdurchlässigen oder durchsichtigen Material, beispielsweise Acrylglas, Polycarbonat odgl.. Dann sollte aber von oben nicht das gesamte Innenleben des Bediengehäuses 11 erkannt werden können. Deswegen kann eine lichtundurchlässige Beschichtung als Abschirmung bzw. Abdeckung an der Außenseite oder der Innenseite bzw. der Bediengehäuseoberseite 12 und/oder der Bediengehäuseunterseite 13 vorgesehen sein. Diese sollte ein gestrichelt dargestelltes Fenster 19 freilassen, durch welches dann eben die erfindungsgemäße Lichtdurchlässigkeit bzw. Durchsichtigkeit erreicht werden kann.

Wie aus der Fig. 3 ersichtlich ist, kann an der Unterkante 16 eine nach unten weisende Dichtung 18 vorgesehen sein. Diese kann in eine Hinterschneidung odgl. an der Unterkante 16 des Bediengehäuserands 15 eingesetzt bzw. eingedrückt sein. Alternativ kann sie auf dem Fachmann an sich bekannte Art und Weise an die Unterkante 16 angespritzt sein, also in einem Mehrkomponenten-Spritzgussverfahren angeformt sein.

Unterhalb des Bediengehäuses 11 ist in der Fig. 1 die Trägerfolie 20 in entsprechender Schrägdarstellung zu sehen. Auf einer Oberseite weist die Trägerfolie 20 mehrere runde kapazitive Sensorelemente 22 auf. Von diesen Sensorelementen 22 gehen Leiter 23 ab zu einer an einem nach unten bzw. vorne abstehenden Ansatz 25 der Trägerfolie 20, auf dem eine Steckeinrichtung 26 angeordnet ist. Die Steckeinrichtung 26 dient zum elektrischen Anschluss der Leiter 23 und somit der kapazitiven Sensorelemente 22. Die kapazitiven Sensorelemente 22 können entweder außerhalb des Fensters 19 angeordnet sein. Dann können sie von oben nicht gesehen werden, so dass ihre Ausbildung grundsätzlich egal ist. Sollten sie ganz oder zumindest teilweise von dem Fenster 19 überlappt werden, so könnten sie von oben gesehen werden. Falls diese Sichtbarkeit nicht gewünscht ist, werden die kapazitiven Sensorelemente 22 aus einem lichtdurchlässigen bzw. durchsichtigen, aber elektrisch leitfähigen Material gefertigt, wie beispielsweise ITO.

Die Trägerfolie 20 ist hier rechteckig dargestellt, wie auch das Bediengehäuse 11, sie kann aber auch eine andere bzw. beliebige Form haben. Allerdings ist sie deutlich kleiner, wobei sie gleichzeitig deutlich größer ist als das Fenster 19. Der hier zu erkennende breite überstehende Rand außerhalb der Sensorelemente 22 bzw. Leiter 23 dient zur Befestigung im Bediengehäuse 11, wie nachfolgend noch näher erläutert wird.

Unterhalb der Trägerfolie 20 ist in entsprechender Schrägdarstellung ein Bauteilträger 30 zu sehen, beispielsweise in Form einer üblichen Leiterplatte. Der Bauteilträger 30 ist grundsätzlich auch rechteckig, muss dies aber nicht sein, wobei er wiederum deutlich größer ist als die Trägerfolie 20 und vorteilhaft zumindest weitgehend dem Innenraum des Bediengehäuses 11 entspricht. In Eckbereichen weist der Bauteilträger 30 Befestigungslöcher 32 auf. Damit kann er beispielsweise an entsprechenden Rastvorsprüngen befestigt werden, die von der Bediengehäuseunterseite 13 nach unten stehen.

Auf einer Oberseite 31 weist der Bauteilträger 30 mehrere Bauteile auf, nämlich ein großflächiges LCD-Display 34, rechts daneben eine einfache LED 35 und an der Vorderseite eine Gegen-Steckeinrichtung 36. In diese Gegen-Steckeinrichtung 36 kann von oben oder von der Seite die Steckeinrichtung 26 der Trägerfolie 20 eingesteckt werden. Des Weiteren ist auf dem Bauteilträger 30 vorteilhaft ein Mikrocontroller angeordnet, also die sogenannte Intelligenz für die Bedieneinrichtung.

In der Fig. 2 sind die drei Bauteile der Fig. 1 noch einmal etwas näher beieinander und übereinander in Seitenansicht dargestellt. Hier kann auch die Reihenfolge des Zusammenbaus erkannt werden. Eine entsprechend zusammengebaute Bedieneinrichtung 38 ist in Fig. 3 dargestellt, wobei diese dabei in ein Kochfeld 40 mit einer Kochfeldplatte 41 und einem Tragblech 48 eingebaut ist.

Zur Herstellung der Bedieneinrichtung 38 wird entsprechend Fig. 2 an die Bediengehäuseunterseite 13 eine vorgefertigte Trägerfolie 20 angesetzt, vorteilhaft direkt angedrückt. Dabei kann sie zur Befestigung zwar grundsätzlich auch durch das Andrücken von unten mittels des danach angebauten Bauteilträgers 30 gehalten werden. Vorteilhaft aber wird die Trägerfolie 20 dauerhaft an der Bediengehäuseunterseite 13 befestigt, insbesondere durch Ankleben oder besonders vorteilhaft durch ein Anspritzen bzw. Hinterspritzen mit Kunststoff 39, wie es in der Fig. 3 dargestellt ist. Ein in Fig. 3 möglicherweise durch die Darstellung vorhandener Spalt zwischen Trägerfolie 20 und Bediengehäuse 11 bzw. Bediengehäuseunterseite 13 sollte in der Praxis nicht vorkommen. Dies beeinträchtigt nämlich die optische Erkennbarkeit des LCD-Displays 34 und der LED 35 als Leuchtanzeigen. Des Weiteren wird, wie dem Fachmann bekannt ist, auch die Funktion der durch die kapazitiven Sensorelemente 22 gebildeten kapazitiven Berührungsschalter 43 beeinträchtigt oder möglicherweise stark gestört. In der Fig. 3 ist zu erkennen, wie also unterhalb der Trägerfolie 20 eine deutlich dickere Schicht aus angespritztem Kunststoff 39 vorgesehen ist. Dieser Kunststoff kann flächig vorgesehen sein und die gesamte Trägerfolie 20 überdecken, insbesondere am Randbereich überlappen und an der Bediengehäuseunterseite 13 anliegen zur festen Verbindung. Dann muss es aber ebenfalls durchsichtiger bzw. lichtdurchlässiger Kunststoff sein für die Leuchtanzeigen 35 und 36. Alternativ kann der Kunststoff 39 als eine Art Rahmen umlaufend nur im äußeren Randbereich der Trägerfolie 20 verlaufen, um so die feste Anbindung an das Bediengehäuse 11 zu schaffen. Im Mittelbereich verbleibt so ein Sichtfenster. Eine weitere einfache Möglichkeit ist das direkte Ankleben der Trägerfolie 20 mit einem außen umlaufenden Kleberand, der entsprechend dem Fenster 19 einen größeren Bereich freilässt. Hierfür könnte Klebeband oder eine Kontaktverklebung mittels Kleber vorgesehen sein.

Aus der Fig. 2 ist mit dem leicht nach unten abstehenden bzw. hängenden Ansatz 25 mit der Steckeinrichtung 26 zu ersehen, dass auch nach dem Befestigen, beispielsweise Einspritzen, der Trägerfolie 20 in das Bediengehäuse 11 ein elektrischer Kontakt an die Gegen-Steckeinrichtung 36 bzw. an den Bauteilträger 30 noch leicht möglich ist. Dessen Befestigung über vorgenannte Rasthaken, Raststifte odgl. sowie ein Festschrauben an Gewindevorsprünge im Bediengehäuse 11 ist für den Fachmann leicht möglich.

Der Bauteilträger kann in dem Bediengehäuse 11 mittels Vorsprünge befestigt werden, die von der Bediengehäuseunterseite 13 nach unten abstehen. Daran kann eine Schraubbefestigung oder eine Rastbefestigung erfolgen. Alternativ können auch von der Seite, also innen vom Bediengehäuserand 15, solche entsprechenden Vorsprünge abstehen. Eine derartige Befestigung ist dem Fachmann aber bekannt und leicht zu realisieren.

Im zusammengebauten Zustand der Bedieneinrichtung 38 entsprechend Fig. 3 ist dann unterhalb der Trägerfolie 20 und unterhalb des Kunststoffs 39 der Bauteilträger 30 vorgesehen mit dem LCD-Display 34 und der LED 35 auf seiner Oberseite 31. Er kann an der Unterseite des Kunststoffs 39 oder der Trägerfolie 20 anliegen, muss aber nicht. Es ist zu erkennen, dass zwischen dem Kunststoff 39 zur Befestigung der Trägerfolie 20 an der Bediengehäuseunterseite 13 und der Oberseite des LCD-Displays 34 ein größerer Luftspalt ist. Dieser stört die Funktion sowie das Erscheinungsbild aber nicht. Die elektrische Kontaktierung des Bauteilträgers 30 an die Trägerfolie 20 ist hier nicht dargestellt, für den Fachmann aber aufgrund der Fig. 1 leicht vorstellbar.

Das Bediengehäuse 11 sitzt mit der Unterkante 16 des Bediengehäuserands 15 bzw. der unten daran angebrachten Dichtung 18 auf einem üblichen Tragblech 48 des Kochfelds 40 auf, auf dem bekanntlich auch hier nicht dargestellte Heizeinrichtungen aufsitzen. Gleichzeitig ist dabei die Bediengehäuseoberseite 12 an die Unterseite 46 der Kochfeldplatte 41 angedrückt. Hier kann insbesondere bei einer an der Unterseite genoppten Kochfeldplatte 41 aus Glaskeramik eine nicht ganz perfekte Anlage bzw. eine Anlage mit Luftspalten vorgesehen sein. Um dies auszugleichen, kann allgemein eine zumindest teilweise lichtdurchlässige bzw. durchsichtige Anpassungsschicht vorgesehen sein bzw. eingespritzt werden, die vorteilhaft elastisch ist, beispielsweise ein weiches Silikon oder ähnliches Material, das nicht elektrisch leitfähig sein darf.

Die gemäß der Erfindung hergestellte und in den Figuren dargestellte Bedieneinrichtung zeichnet sich dadurch aus, dass in das Bediengehäuse relativ leicht andere Trägerfolien und/oder andere Bauteilträger 30 eingebaut werden können mit dem Vorteil, dass nicht jedes Mal eine komplette neue Bedieneinrichtung entworfen werden muss sowie deren Unterbringung in einem Kochfeld. Gerade die Fig. 1 zeigt deutlich, dass Trägerfolie 20 und/oder Bauteilträger 30 relativ leicht variiert werden können, während die anderen Teile, insbesondere auch das Bediengehäuse 11, gleich bleiben können.

Durch die nach oben vorgesehene geschlossene Bediengehäuseoberseite 12, die entsprechend Fig. 3 an der Unterseite 46 einer Kochfeldplatte 41 als Bedienfeld oder Bedienfläche anliegen kann, sowie die Befestigung der Trägerfolie 20 mit den kapazitiven Sensorelementen 22 darauf direkt an der Bediengehäuseunterseite 13, ist eine definierte geometrische Anordnung gegeben. Somit sind sowohl die optischen Darstellungsverhältnisse für die Leuchtanzeigen in Form des LCD-Displays 34 und der LED 35 als auch die elektrischen Verhältnisse für den Betrieb der kapazitiven Berührungsschalter 43 gut.

## Patentansprüche

1. Bedieneinrichtung für ein Elektrogerät mit mindestens einem kapazitiven Berührungsschalter und einem Bediengehäuse, wobei
- der kapazitive Berührungsschalter ein kapazitives Sensorelement aufweist,
- das Sensorelement auf einer Trägerfolie angeordnet ist,
- auf der Trägerfolie elektrische Leiter zum Anschluss des kapazitiven Sensorelements vom Sensorelement zu einer Anschlusseinrichtung an der Trägerfolie verlaufen,
- das Bediengehäuse eine flache Bediengehäuseoberseite aufweist mit einem zumindest teilweise nach unten abstehenden Bediengehäuserand, der zumindest teilweise umläuft,
- die Trägerfolie an der Unterseite der Bediengehäuseoberseite befestigt ist,
**dadurch gekennzeichnet, dass**
- in dem Bediengehäuse unterhalb der Trägerfolie ein Bauteilträger mit elektrischen Bauteilen und mindestens einer Leuchtanzeige der Bedieneinrichtung vorgesehen ist,
- die Trägerfolie an den Bauteilträger elektrisch angeschlossen ist,
- die Trägerfolie und die Bediengehäuseoberseite zumindest bereichsweise lichtdurchlässig sind oberhalb der Leuchtanzeige.

2. Bedieneinrichtung nach Anspruch 1, **dadurch gekennzeichnet, dass** die Trägerfolie an der Unterseite der Bediengehäuseoberseite dauerhaft und unlösbar befestigt ist, insbesondere integral mit dieser hergestellt ist oder mittels Kunststoffspritzguss angespritzt ist.

3. Bedieneinrichtung nach Anspruch 1 oder 2, **dadurch gekennzeichnet, dass** die Trägerfolie an der Unterseite der Bediengehäuseoberseite großflächig anliegt, vorzugsweise vollflächig.

4. Bedieneinrichtung nach einem der vorhergehenden Ansprüche, **dadurch gekennzeichnet, dass** die Anschlusseinrichtung nach der Befestigung der Trägerfolie an der Unterseite der Bediengehäuseoberseite noch zugänglich ist bzw. absteht, vorzugsweise mit einem flexiblen Abschnitt bzw. bewegbar hervorsteht.

5. Bedieneinrichtung nach einem der vorhergehenden Ansprüche, **dadurch gekennzeichnet, dass** der Bauteilträger im Bediengehäuse befestigt ist und mittels der Anschlusseinrichtung mit der Trägerfolie elektrisch verbunden ist.

6. Bedieneinrichtung nach einem der vorhergehenden Ansprüche, **dadurch gekennzeichnet, dass** mindestens ein kapazitives Sensorelement oberhalb der Leuchtanzeige auf dem Bauteilträger angeordnet ist, vorzugsweise über der Leuchtanzeige.

7. Bedieneinrichtung nach einem der vorhergehenden Ansprüche, **dadurch gekennzeichnet, dass** die Bediengehäuseoberseite lichtdurchlässig ist, insbesondere im Wesentlichen lichtdurchlässig bzw. zu mindestens 90% durchsichtig ist und aus lichtdurchlässigem Material besteht.

8. Bedieneinrichtung nach einem der vorhergehenden Ansprüche, **dadurch gekennzeichnet, dass** die Trägerfolie lichtdurchlässig ist, insbesondere im Wesentlichen lichtdurchlässig bzw. zu mindestens 90% durchsichtig ist und aus lichtdurchlässigem Material besteht.

9. Bedieneinrichtung nach einem der vorhergehenden Ansprüche, **dadurch gekennzeichnet, dass** das Bediengehäuse einteilig und integral hergestellt ist, insbesondere aus einem durchgehend gleichen Material.

10. Bedieneinrichtung nach einem der vorhergehenden Ansprüche, **dadurch gekennzeichnet, dass** an der Bediengehäuseoberseite eine lichtundurchlässige Abdeckung aufgebracht ist, wobei insbesondere die Abdeckung einen die Leuchtanzeigen auf dem Bauteilträger umgebenden bzw. freilassenden Ausschnitt bzw. mehrere Ausschnitte aufweist.

11. Bedieneinrichtung nach einem der vorhergehenden Ansprüche, **dadurch gekennzeichnet, dass** der Bediengehäuserand nach unten absteht und weitgehend umlaufend ausgebildet ist, wobei vorzugsweise an einer Unterkante des Bediengehäuserandes Dichtungsmittel nach unten vorgesehen sind, insbesondere angespritzt sind.

12. Elektrogerät, **gekennzeichnet durch** eine Bedieneinrichtung nach einem der vorhergehenden Ansprüche, die unter einer Bedienblende des Elektrogeräts angeordnet ist bzw. die an die Unterseite der Bedienblende angedrückt ist.

13. Elektrogerät nach Anspruch 12, **dadurch gekennzeichnet, dass** es ein Kochfeld mit einer lichtdurchlässigen Kochfeldplatte ist, wobei die Bedieneinrichtung unter der Kochfeldplatte als Bedienblende angeordnet ist bzw. an die Unterseite der Kochfeldplatte angedrückt ist, wobei das Bediengehäuse auf einer Tragplatte bzw. einem Tragblech des Kochfelds aufliegt.

14. Verfahren zur Herstellung einer Bedieneinrichtung nach einem der Ansprüche 1 bis 11, **dadurch gekennzeichnet, dass** eine Trägerfolie mit mindestens einem kapazitiven Sensorelement und einem elektrischen Leiter samt einer Anschlusseinrichtung an einer Unterseite einer Bediengehäuseoberseite befestigt wird, wobei danach ein Bauteilträger mit elektrischen Bauteilen und/oder einer Steuerung der Bedieneinrichtung in dem Bediengehäuse unterhalb der Trägerfolie angeordnet wird.

15. Verfahren nach Anspruch 14, **dadurch gekennzeichnet, dass** die Trägerfolie mit dem kapazitiven Sensorelement und dem elektrischen Leiter samt der Anschlusseinrichtung mittels Kunststoffspritzguss an der Unterseite der Bediengehäuseoberseite angespritzt wird zur Befestigung.
